# EUROPÄISCHE PATENTANMELDUNG

(11) **EP 0 749 209 A1**
(43) Veröffentlichungstag der Anmeldung: **18.12.1996**
(21) Anmeldenummer: 96108530.5
(22) Anmeldetag: 29.05.1996
(51) Int. Cl.: H03K 17/945

(54) **Elektrisches Schaltgerät**

(30) Priorität: 12.06.1995 DE 19521361
(71) Anmelder: SIEMENS AKTIENGESELLSCHAFT, 80333 München (DE)
(72) Erfinder: Bäuml, Alfred, Dipl.-Ing., 92442 Wackersdorf (DE); Rothut, Otto, 92421 Schwandorf (DE); Schuster, Hubert, Dipl.-Ing., 92289 Ursensollen (DE)

(57) **Zusammenfassung**

Die Erfindung bezieht sich auf ein elektrisches Schaltgerät (1) mit einem hülsenförmigen Gehäuse (5), in dessen einen Endbereich ein Sensor (2) an der Innenwand des Gehäuses (5) angeklebt ist. Erfindungsgemäß ist die Innenwand des Gehäuses (5) im Klebebereich mit einem Gewinde (6) versehen, das mit Kleber ausgefüllt ist. Hierdurch ist das Gehäuse (5) relativ großflächig mit Kleber benetzt. Es ergibt sich eine feste und zugleich dichte Verbindung mit dem Sensor (2) und ggf. einen Gießring (4), die einer Beanspruchung des Schaltgeräts (1) mit hohen äußeren Drücken standhält.

## Beschreibung

Die Erfindung bezieht sich auf ein elektrisches, insbesondere berührungslos arbeitendes Schaltgerät mit einem hülsenförmigen Gehäuse, in dessem einen Endbereich ein zylindrisch geformter Sensor steckt, wobei der Sensor über seine Zylinderoberfläche mit der Innenwand des hülsenförmigen Gehäuses verklebt ist.

Ein gattungsgemäßes Schaltgerät ist durch Angebot und Lieferung von Elektrofirmen seit geraumer Zeit bekannt. Dabei ist der Sensor Bestandteil eines Gießlings mit einer vergossenen elektrischen Schaltung und mit dieser elektrisch verbunden. Die bisherige Verklebung von Gießling und Hülse gewährleistet keine ausreichende Dichtigkeit, die einen Betrieb des Schaltgeräts bei Beaufschlagung von Drücken von z.B. 8 bar ohne Störung ermöglicht.

Daher liegt der Erfindung die Aufgabe zugrunde, ein elektrisches Schaltgerät der obengenannten Art zu schaffen, das höheren Drücken standhält, ohne daß sein Betrieb gestört ist.

Erfindungsgemäß wird die Aufgabe einmal dadurch gelöst, daß die Innenwand des Gehäuses im Klebebereich mit mindestens einer Rille versehen ist, die mit Kleber ausgefüllt ist.

Gemäß einer vorteilhaften Weiterbildung dieser Erfindung ist die Innenwand des Gehäuses im Klebebereich mit einem ersten Gewinde als Rille versehen.

Der Sensor ist vorzugsweise Bestandteil eines Gießlings mit einer vergossenen Schaltung.

Gemäß einer weiteren erfindungsgemäßen Lösung ist die Zylinderoberfläche des Sensors mit einem zweiten Gewinde versehen.

Ausführungsbeispiele der Erfindung werden im folgenden anhand einer Zeichnung näher erläutert. Es zeigen:
- FIG 1: ein elektrisches, berührungslos arbeitendes Schaltgerät,
- FIG 2: einen Gießling mit einem Sensor und einer elektrischen Schaltung,
- FIG 3: einen Endbereich des hülsenförmigen Gehäuses des Schaltgeräts gemäß FIG 1,
- FIG 4: den Sensor gemäß FIG 2 mit einem Gewinde,
- FIG 5: den Sensor mit Gießling gemäß FIG 2 mit einem Gewinde.

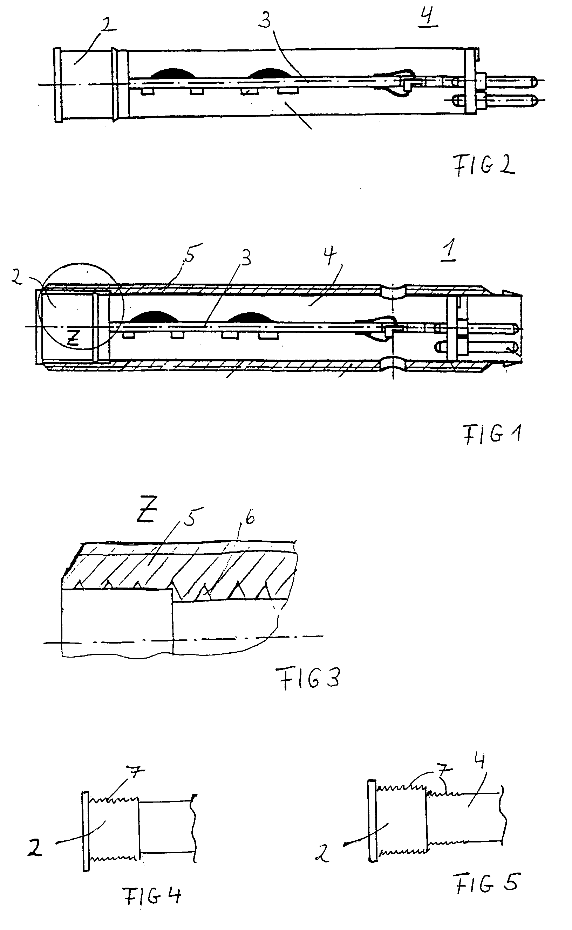

FIG 1 zeigt ein elektrisches, berührungslos arbeitendes Schaltgerät 1, z.B. einen induktiv, kapazitiv oder optoelektrisch betriebenen Näherungsschalter, mit einem entsprechenden, äußerlich meist zylindrisch gestalteten Sensor 2, der mit einer elektrischen Schaltung 3 verbunden ist und, wie FIG 2 zeigt, in einem ebenfalls zylindrisch ausgebildeten Gießling 4 vorvergossen sein kann. Der Gießling 4 ist gemäß FIG 1 in einer als Gehäuse dienenden Hülse 5 verklebt, wozu deren Innendurchmesser und der Außendurchmesser des Gießlings 4 einander angepaßt sind. Im Endbereich der Hülse 5, in dem der Sensor 2 liegt, ist deren Innenwand mit Rillen, z.B. einem Gewinde 6 (siehe FIG 3) versehen, die mit Kleber ausgefüllt sind. Auf diese Weise ist die Hülse 5 relativ großflächig mit Kleber benetzt, und es ergibt sich eine feste und zugleich dichte Verbindung mit dem Gießling 4 oder auch nur mit dem Sensor 2, die einer Beanspruchung des Schaltgeräts 1 mit hohen Drücken von z.B. 8 bar standhält und die Funktionstüchtigkeit des Schaltgeräts 1 nicht beeinträchtigt. Bei den alternativ ausgeführten, druckfesten Schaltgeräten 1 ist anstelle der Hülseninnenwand die Manteloberfläche des Sensors 2 ausschließlich gemäß FIG 4 oder aber zusätzlich mit einem Teil der Zylinderoberfläche des Gießlings 4 mit einem Gewinde 7 gemäß FIG 5 versehen, das im verklebten Zustand mit Kleber ausgefüllt ist.

Die Verklebung erfolgt, in dem zunächst die Oberfläche des Gießlings 4 und des Sensors 2 mit Kleber benetzt werden und anschließend der Gießling 4 mit dem Sensor 2 in die aufrecht gehaltene Hülse 5 eingeschoben wird, worauf der Kleber aufgrund der Schwerkraft zum sensorseitigen Ende fließt und dabei den durch die Rillen bzw. das Gewinde 6 gebildeten Zwischenraum ausfüllt.

## Patentansprüche

1. Elektrisches, insbesondere berührungslos arbeitendes Schaltgerät (1) mit einem hülsenförmigen Gehäuse (5), in dessem einen Endbereich ein zylindrisch geformter Sensor (2) steckt, wobei der Sensor (2) über seine Zylinderoberfläche mit der Innenwand des hülsenförmigen Gehäuses (5) verklebt ist, **dadurch gekennzeichnet,** daß die Innenwand des Gehäuses (5) im Klebebereich mit einer Rille (6) versehen ist, die mit Kleber ausgefüllt ist.

2. Elektrisches, insbesondere berührungslos arbeitendes Schaltgerät nach Anspruch, **dadurch gekennzeichnet,** daß die Innenwand des Gehäuses (5) im Klebebereich mit einem ersten Gewinde (6) als Rille versehen ist.

3. Elektrisches, insbesondere berührungslos arbeitendes Schaltgerät nach Anspruch 1 oder 2, **dadurch gekennzeichnet,** daß der Sensor (2) Bestandteil eines Gießlings (4) mit einer vergossenen Schaltung (3) ist.

4. Elektrisches, insbesondere berührungslos arbeitendes Schaltgerät (1) mit einem hülsenförmigen Gehäuse (5), in dessem einen Endbereich ein zylindrisch geformter Sensor (2) steckt, wobei der Sensor (2) über seine Zylinderoberfläche mit der Innenwand des hülsenförmigen Gehäuses (5) verklebt ist, **dadurch gekennzeichnet,** daß die Zylinderoberfläche des Sensors (2) mit einem zweiten Gewinde (7) versehen ist.

5. Elektrisches, berührungslos arbeitendes Schaltgerät nach Anspruch 4, **dadurch gekennzeichnet,** daß der Sensor (2) Bestandteil eines Gießlings (4) mit einer vorvergossenen Schaltung (3) ist.
